Europäisches Patentamt

European Patent Office

Office européen des brevets

(19)

(11) Numéro de publication: 0 378 458
A1

(12) # DEMANDE DE BREVET EUROPEEN

(21) Numéro de dépôt: 90400034.6

(51) Int. Cl.⁵: H05K 7/20

(22) Date de dépôt: 05.01.90

(30) Priorité: 13.01.89 FR 8900372

(43) Date de publication de la demande:
18.07.90 Bulletin 90/29

(84) Etats contractants désignés:
DE GB

(71) Demandeur: THOMSON-CSF
51, Esplanade du Général de Gaulle
F-92800 Puteaux(FR)

(72) Inventeur: Sauzade, Jean
THOMSON-CSF SCPI Cédex 67
F-92045 Paris la Défense(FR)
Inventeur: Thomas, Hervé
THOMSON-CSF SCPI Cédex 67
F-92045 Paris la Défense(FR)
Inventeur: Beignis, Noel
THOMSON-CSF SCPI Cédex 67
F-92045 Paris la Défense(FR)

(74) Mandataire: Courtellemont, Alain et al
THOMSON-CSF SCPI
F-92045 PARIS LA DEFENSE CEDEX 67(FR)

(54) **Dispositif de refroidissement pour bac à cartes, et bac à cartes comportant au moins un tel dispositif.**

(57) L'invention concerne des bacs à cartes électroniques (5) dans lesquels peuvent être montés indifféremment des cartes en technologie classique requérant un refroidissement par circulation d'air forcé ou des cartes à drain thermique requérant un refroidissement par conduction du drain vers la plaque à rainure servant de support à la carte.

Pour cela les dispositifs de refroidissement sont constitués par des plaques à rainures (1) percées d'ouvertures permettant de souffler, à travers la plaque, de l'air vers les cartes ; de plus ces plaques comportent une canalisation (3) pour liquide de refroidissement afin de refroidir l'air soufflé et d'améliorer le refroidissement par conduction dans le cas de cartes à drain.

Application aux bacs à cartes électroniques.

FIG_7

## DISPOSITIF DE REFROIDISSEMENT POUR BAC A CARTES ET BAC A CARTES COMPORTANT AU MOINS UN TEL DISPOSITIF

La présente invention concerne le refroidissement des cartes électroniques disposées dans un bac, le terme bac désignant ici tout ensemble muni d'au moins une paire de plaques, dans lequel les cartes sont maintenues entre deux sortes de rails parallèles portés respectivement par les deux plaques d'une même paire.

Les cartes électroniques utilisées dans ces bacs peuvent comporter un drain thermique, c'est-à-dire une plaque métallique sur laquelle est posée la carte proprement dite avec son substrat isolant et ses composants. Dans le cas où la carte ne comporte pas de drain thermique, elle est maintenue dans les rails parallèles par deux côtés opposés de son substrat isolant. La dissipation des calories dégagées par les composants de la carte ne peut alors se faire qu'avec l'air ambiant et il est courant d'améliorer les échanges par une circulation d'air forcée. Dans le cas ou la carte comporte un drain, elle est maintenue dans les rails parallèles par deux côtés opposés de son drain si bien que le refroidissement de la carte s'effectue non seulement par l'air ambiant, mais aussi par conduction des composants électroniques vers les plaques, en passant par le substrat puis le drain de la carte.

Lorsque le refroidissement doit être puissant parce que la puissance thermique volumique est très importante, les dispositifs de refroidissement par la seule circulation d'air forcée nécessitent des ventilateurs dont l'encombrement est généralement trop élevé, de même que le bruit acoustique qu'ils produisent. Il est alors commun d'utiliser des cartes à drain et, pour les maintenir, des plaques massives vers lesquelles les calories peuvent facilement s'écouler. Mais, du fait des plaques massives, la circulation d'air forcée n'est pas possible ce qui oblige à employer des cartes à drain, même dans les cas où la puissance à dissiper est faible, car en général le simple refroidissement par l'air ambiant en circulation naturelle ne suffit pas du fait de la proximité des cartes à forte puissance thermique volumique ; or les cartes à drain sont d'un prix de revient élevé et la transformation, qui consiste à prendre une carte en technologie classique pour lui adjoindre un drain, est coûteuse et même, parfois, impossible.

De même les bacs conçus pour les cartes classiques ne permettent pas le refroidissement des cartes à drain car leurs plaques ne peuvent, en général, pas assurer une échappatoire suffisante aux calories produites par les composants et non évacuées par la circulation d'air.

La présente invention a pour but d'éviter ou, pour le moins, de réduire ces inconvénients.

Ceci est obtenu à l'aide d'un dispositif de refroidissement formé d'une plaque spécialement conçue à cet effet.

Selon l'invention, il est proposé un dispositif de refroidissement pour un bac à cartes, constitué par une plaque destinée à positionner des cartes électroniques dans le bac à l'aide de guide-carte maintenus au moins à leurs deux extrémités par la plaque, cette plaque comportant une canalisation prévue pour la circulation de liquide de refroidissement , caractérisé en ce que la plaque comporte un châssis percé d'ouvertures oblongues disposées sensiblement au niveau des emplacements prévus pour le positionnement des cartes contre la plaque, ces ouvertures étant destinées au passage de l'air à travers la plaque.

La présente invention sera mieux comprise et d'autres caractéristiques apparaîtront à l'aide de la description ci-après et des figures s'y rapportent qui représentent :

- la figure 1, une vue partielle en coupe montrant un dispositif selon l'invention,
- la figure 2, une vue en perspective d'un élément associé, sur la figure 1, au dispositif selon l'invention,
- la figure 3, le dispositif de la figure 1 vu de dessous,
- les figures 4 et 5, des vues de dessus, en coupe, et de côté de l'une des parties qui constituent le dispositif selon les figures 1 et 3,
- la figure 6, une vue d'une autre partie du dispositif selon les figures 1 et 3,
- la figure 7, une vue très partielle, dans le plan de coupe, du dispositif selon les figures 1 et 3.

Sur les différentes figures, les éléments correspondants sont désignés par les mêmes repères.

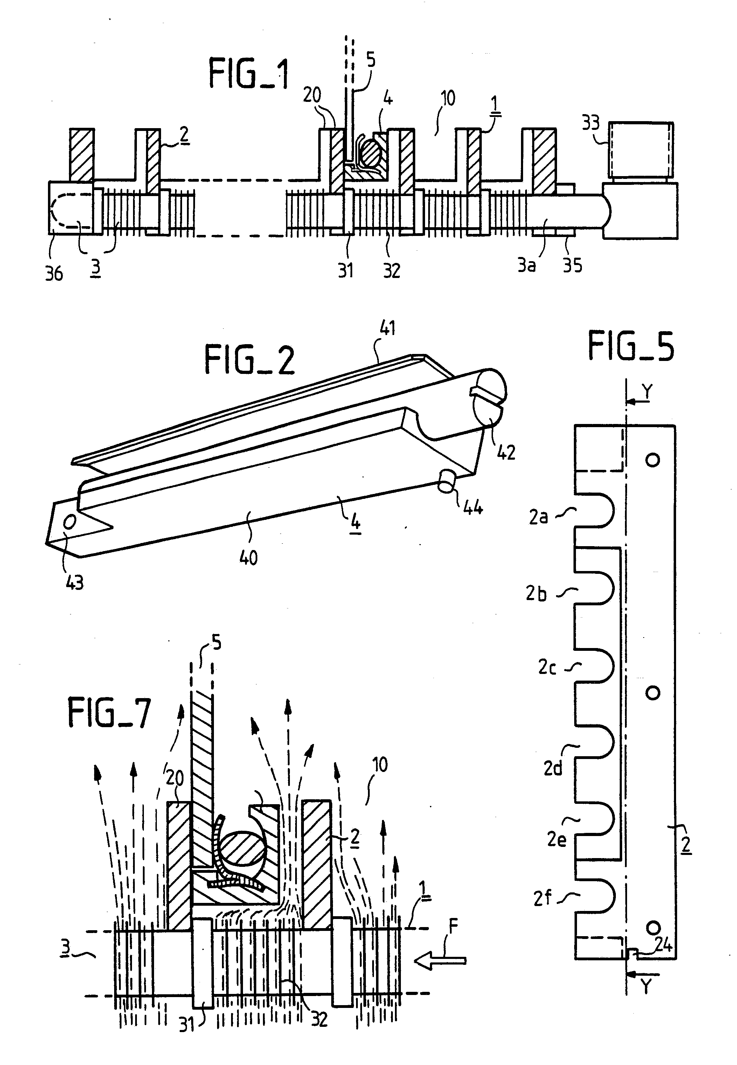

La figure 1 montre en vue partielle une plaque 1 comportant des rainures telles que 10 dans lesquelles, pour assurer le maintien de cartes électroniques telles que 5, sont montés des guide-carte 4. La carte est prévue pour être montée avec ses rainures parallèles et faisant face aux rainures d'une autre carte afin que la carte 5 puisse être introduite, perpendiculairement au plan de la figure, dans les espaces en regard compris chacun entre la lame élastique d'un guide-carte et la paroi de la rainure située à proximité de cette lame.

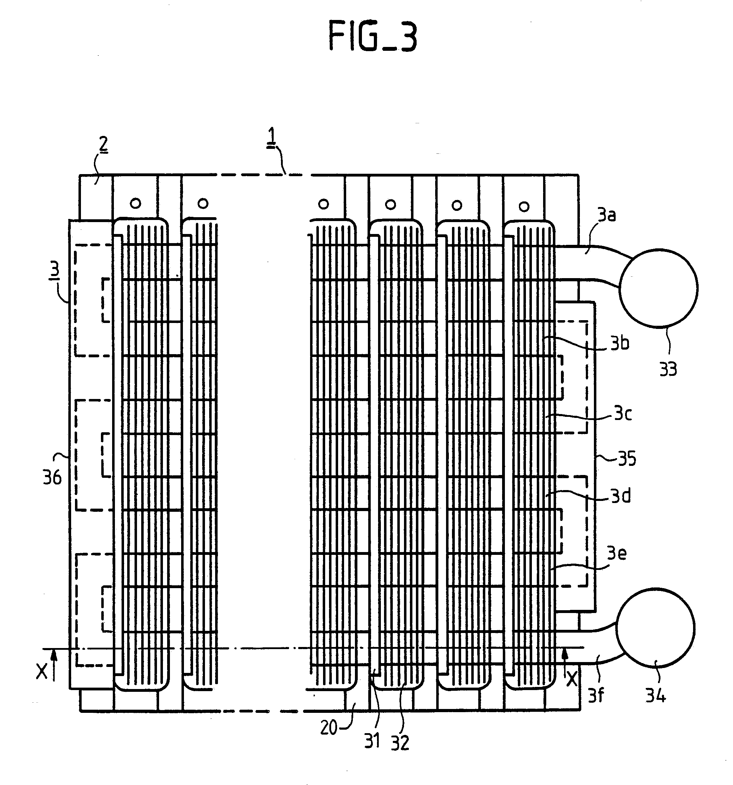

La figure 2 montre, vu en perspective, un guide-carte, 4, utilisé dans l'exemple décrit. Ce guide-carte comporte un corps longitudinal 40 à section sensiblement en équerre, une lame élastique 41 solidaire du corps 40 et une came 42 prisonnière entre le corps et la lame et qui peut être tournée, pour écarter la lame de sa position de repos ou l'y ramener. La corps 40 est percé à l'une de ses extrémités d'un trou de fixation 43 et comporte, à son autre extrémité, un ergot 44.

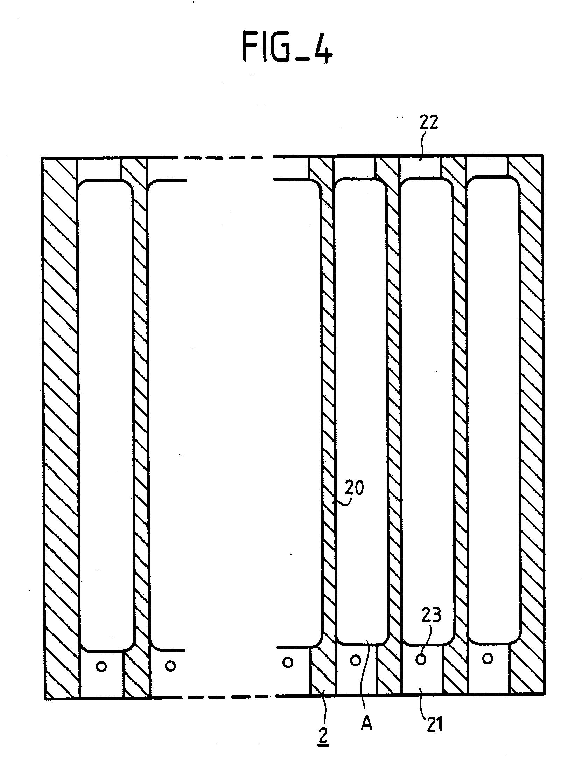

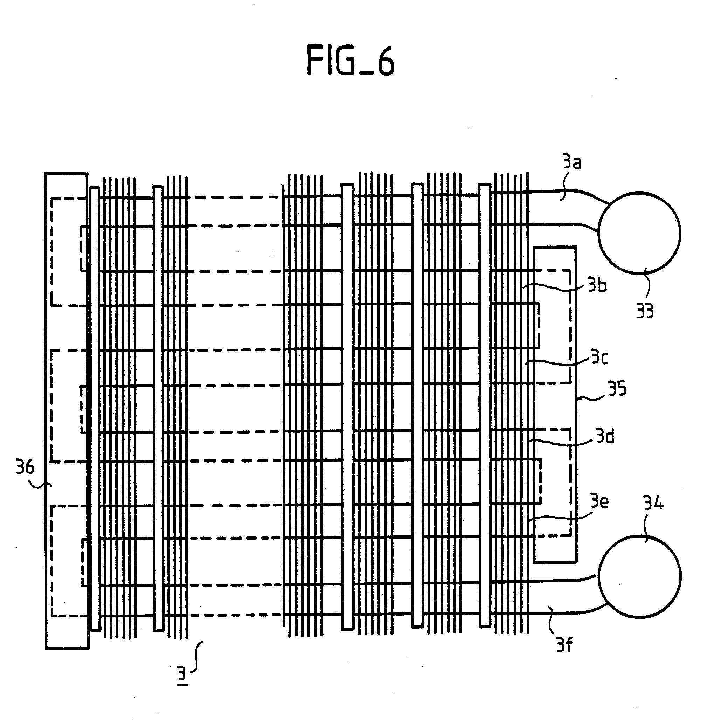

La plaque 1 de la figure 1 est composée de deux parties : un châssis 2 qui sera décrit plus en détail à l'aide figures 4 et 5, et une canalisation 3 qui sera montrée, seule, vue de dessous, sur les figures 3 et 6 : elle est assemblée avec le châssis 2 dans le cas de la figure 3 et seule dans le cas de la figure 6. Par convention, vue de dessous signifie vue du côté de la plaque opposé aux cartes et vue de dessus signifie vue à partir de l'emplacement des cartes électroniques.

Pour la figure 1, la coupe n'a été réalisée que dans le châssis 2 et a été faite de manière à montrer la canalisation 3 ; la trace XX du plan de coupe du châssis 2 a été indiquée sur la figure 3. Comme il apparaît par l'observation des figures 1, 3 et 6, la canalisation 3 est composée de six tronçons de tuyaux parallèles 3a à 3f montés en série grâce à des pièces de raccordement 35 et 36 munies respectivement de 2 et 3 liaisons faisant communiquer les tronçons de tuyaux. Ainsi est réalisé, dans un plan, un serpentin dont les accès, qui se trouvent respectivement aux extrémités libres des tronçons 3a et 3f, sont constitués par des bornes de branchement 33 et 34. Ce serpentin est destiné à faire circuler un liquide de refroidissement constitué, dans l'exemple décrit, par de l'eau.

Comme il ressort en particulier de la figure 1, à chaque rainure, telle que 10, de la plaque 1, correspond un groupe fait de six ailettes fines telles que 32 et une ailette massive telle que 31. Ces ailettes sont formées de plaquettes métalliques percées chacune de six trous dans lesquels sont respectivement enfilés les six tronçons de tuyaux 3a à 3f. L'assemblage des ailettes, des pièces de raccordement 35, 36 et des bornes 33 et 34 est réalisé à l'aide d'un gabarit de montage.

Les figures 4 et 5 montrent respectivement en coupe vue de dessous et en vue de côté, à partir de l'emplacement des bornes d'accès de la canalisation 3, comment est réalisé le châssis 2. la plan en coupe de la figure 4 est repéré par sa trace YY dans le plan de la figure 5. la châssis 2 est constitué par une sorte de grille formée de barreaux parallèles, tels que 20, réunis entre eux, à leurs extrémités, par des sortes de tronçons de barres tels que 21 et 22, moins épais que les barreaux et qui forment ainsi des paliers tels que 21 et 22 sur lesquels viennent reposer les guide-carte comme le guide-carte 4 de la figure 1. Les paliers d'un des côtés de la grille constituant le châssis, sont percés de trous tels que 23, qui sont destinés à permettre la fixation des guide-carte au moyen de vis et d'écrous ; le côté de la grille opposé à celui où les paliers sont percés de trous de fixation, comporte une encoche longitudinale 24 qui assure le blocage des ergots 44 des guide-carte et, avec l'ensemble vis-écrous sus mentionné, l'immobilisation des guide-carte dans leur logement.

La figure 5 montre également que le châssis 2 comporte sur sa face inférieure des gorges 2a à 2f percées dans les barreaux telles que 20, de manière à permettre d'y faire pénétrer les tronçons 3a à 3f de la canalisation 3 à des endroits où, par construction, cette canalisation ne comporte pas d'ailettes. Pour ce qui est des ailettes, elles pénètrent dans les ouvertures oblongues telles que l'ouverture repérée A sur la figure 4 et se trouvent ainsi disposées perpendiculairement aux grandes faces du châssis 2 et donc de la plaque 1. Le châssis 2 et la canalisation 3 sont conçus de manière que les plaques massives telles que 31 soient en contact avec les parois des barreaux tels que 20, afin d'assurer une bonne conduction thermique entre le châssis 2 et la canalisation 3. Après assemblage de la canalisation 3 sous le châssis 2, les pièces sont rendues solidaires par soudure à l'étain.

La figure 7 reprend la vue de la figure 1 au voisinage du guide-carte 4 mais à une échelle plus grande et en ne montrant que la partie du châssis 2 située dans le plan de coupe. Alors que, sur la figure 1, la came du guide-carte était en position repos, sur la figure 2, elle est représentée en position travail, bloquant ainsi la carte électronique 5 contre paroi du barreau 20 du châssis 2.

Sur la figure 7, des traits interrompus fins figurent le flux d'air produit par un système de ventilation, non représenté sur la figure, qui souffle de l'air sur la face arrière de la plaque 1. Cet air passe entre les ailettes de la canalisation 3 et traverse le châssis 2 à travers les trous oblongs de ce châssis, en contournant, là où ils existent, les guide-carte pour, ensuite, souffler sur les faces des cartes électroniques telles que 5.

Ainsi dans le cas où la partie de la carte électronique 5, qui est représentée sur la figure 7 est un substrat isolant, c'est-à-dire dans le cas dont il a été question plus avant, d'une carte en technologie classique, le refroidissement de la carte est obtenu par ventilation des deux faces de la carte et il est à noter que l'air soufflé sur la carte est refroidi lors de son passage entre les ailettes de la canalisation.

Dans le cas où la partie de la carte électronique 5, qui est représentée sur la figure 7, est un drain thermique, le refroidissement de la carte est obtenu en partie par la ventilation d'air, mais aussi, et surtout, par une conduction du drain vers le châssis 2 et du châssis 2 vers la canalisation 3, avec évacuation des calories par le liquide caloporteur circulant dans la canalisation et symbolisé par une flèche F, sur la figure 7.

L'invention n'est pas limitée à l'exemple décrit mais englobe toute réalisation dans laquelle une plaque de bac à carte est refroidie par circulation de liquide et comporte des ouvertures à travers lesquelles il est possible de souffler de l'air sur les cartes du bac. En particulier, la canalisation peut ne pas comporter un serpentin plan muni d'ailettes mais un ensemble de tubes plus fins que les tronçons de tuyaux dont il a été question dans la description ci-avant, ces tubes étant montés en parallèle pour assurer un refroidissement efficace.

**Revendications**

1. Dispositif de refroidissement pour un bac à cartes, constitué par une plaque (1) destinée à positionner des cartes électroniques (5) dans le bac à l'aide de guide-carte (4) maintenus au moins à leurs deux extrémités par la plaque, cette plaque comportant une canalisation (3) prévue pour la circulation de liquide de refroidissement, caractérisé en ce que la plaque comporte un châssis (2) percé d'ouvertures oblongues (A) disposées sensiblement au niveau des emplacements prévus pour le positionnement des cartes (5) contre la plaque, ces ouvertures étant destinées au passage de l'air à travers la plaque.

2. Dispositif selon la revendication 1, caractérisé en ce que la canalisation comporte des ailettes (31, 32) disposées dans les ouvertures perpendiculairement aux grandes faces de la plaque.

3. Dispositif selon la revendication 2, caractérisé en ce que, dans chaque ouverture, au moins une des allettes (31) est plaquée contre la paroi de l'ouverture.

4. Dispositif selon la revendication 3, caractérisé en ce que les ailettes (31), qui sont plaquées contre la paroi d'ouvertures, sont plus épaisses que les autres ailettes (32).

5. Dispositif selon la revendication 1, caractérisé en ce que la canalisation (3) comporte un serpentin (3a-3f, 35, 36) disposé sensiblement dans un plan.

6. Dispositif selon la revendication 5, caractérisé en ce que le serpentin est constitué de tronçons de tuyaux parallèles (3a-3f) et de pièces de raccordement (35, 36) disposées aux extrémités des tronçons pour les raccorder en série, et en ce que des ailettes sont enfilées (31, 32) sur les tronçons de tuyaux.

7. Bac à cartes caractérisé en ce qu'il comporte au moins un dispositif selon l'une des revendications précédentes.

# FIG_1

# FIG_2

# FIG_5

# FIG_7

# FIG_3

# FIG_4

# FIG_6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-199621 (SOCAPEX) <br> * colonne 3, lignes 1 - 30; figures 2, 6a-c * | 1 | H05K7/20 |
| A | | 5, 6 | |
| Y | FR-A-2136957 (COMPAGNIE GENERALE DE CONSTRUCTIONS TELEPHONIQUES) <br> * page 2, ligne 38 - page 3, ligne 12; revendication 1; figure 1 * | 1 | |
| A | US-A-4514746 (LUNDQVIST) <br> * colonne 7, lignes 11 - 46; figures 3, 5, 6 * | 2, 6 | |
| A | US-A-3631325 (WENZ) <br> * colonne 2, lignes 20 - 45; figure 1 * | 1 | |

**DOMAINES TECHNIQUES RECHERCHES (Int. Cl.5)**

H05K

Le présent rapport a été établi pour toutes les revendications

| Lieu de la recherche | Date d'achèvement de la recherche | Examinateur |
|---|---|---|
| LA HAYE | 13 FEVRIER 1990 | BARANSKI I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

    & : membre de la même famille, document correspondant

EPO FORM 1503 03.82 (P0402)